# EUROPÄISCHE PATENTSCHRIFT

(11) **EP 0 682 813 B1**
(45) Veröffentlichungstag und Bekanntmachung des Hinweises auf die Patenterteilung: **23.08.2000**
(21) Anmeldenummer: 94905726.9
(22) Anmeldetag: 28.01.1994
(51) Int. Cl.: H01L 31/058, H01L 31/048, F24J 2/04, F24J 2/34

(54) **SOLARZELLENANORDNUNG**
SOLAR CELL ARRANGEMENT
AGENCEMENT DE CELLULES SOLAIRES

(30) Priorität: 06.02.1993 DE 4303538; 11.03.1993 DE 4307705
(43) Veröffentlichungstag der Anmeldung: 22.11.1995
(73) Patentinhaber: Ecotec Solar GmbH, 45886 Gelsenkirchen (DE)
(72) Erfinder: FIEBACK, Klaus, D-10369 Berlin (DE); MATZAT, Norbert, D-22457 Hamburg (DE); KRÄMER, Thomas, D-74740 Adelsheim (DE); BAUERFEIND, Götz, D-04613 Lucka (DE)
(74) Vertreter: Müller, Enno, Dipl.-Ing.
(86) Internationale Anmeldenummer: EP9400244
(87) Internationale Veröffentlichungsnummer: WO9418708

(56) Entgegenhaltungen:
- DE-A- 2 847 433
- DE-A- 3 112 468
- DE-A- 3 831 631
- GB-A- 2 214 710
- US-A- 3 268 366
- US-A- 4 286 576
- US-A- 4 498 459
- US-A- 4 532 917
- US-A- 4 832 755
- PATENT ABSTRACTS OF JAPAN vol. 14, no. 297 (E-945) 27. Juni 1990 & JP,A,02 095 185 (AGENCY OF IND SCIENCE & TECHNOL.) 5. April 1990
- PATENT ABSTRACTS OF JAPAN vol. 8, no. 131 (E-251) (1568) 19. Juni 1984 & JP,A,59 043 578 (NIPPON DENSO KK) 10. März 1984
- PATENT ABSTRACTS OF JAPAN vol. 3, no. 122 (M-76) 13. Oktober 1979 & JP,A,54 100 557 (MATSUSHITA ELECTRIC IND CO LTD) 8. August 1979

## Beschreibung

Die Erfindung betrifft eine Solarzellenanordnung, wobei die Solarzellen mit einem Fluid zur Abführung von Wärme zusammengeschaltet sind.

Derartige Solarzellenanordnungen sind an sich bekannt. Es wird zum Beispiel auf die GB-A-2 214 710 verwiesen, die einen Solarkollektor zur simultanen Umwandlung von Sonnenstrahlung in elektrische und in thermische Energie offenbart. Bei der daraus bekannten Solarzellenanordnung sind Solarzellen in Strahlungsrichtung vor einem thermischen Absorber angeordnet, wobei die Solarzellen zumindest einseitig von einem Wärmetransferfluid angeströmt sind, wodurch eine Kühlung der Solarzellen angestrebt wird.

Weiter wird hinsichtlich der möglichen Verwendung von Paraffin als magnetisches wärmeabführendes Fluid auf das Patent Abstracts of Japan VOL.3, No.122 (M-076) & JP-A-54 100 557 (Matsushita Electric IND.CO.) verwiesen.

Hintergrund einer solchen Technik ist eine möglichst effektive Nutzung sowohl der elektrischen Energie, welche die Solarzellen erzeugen, wie auch der thermischen Energie, welche bei der Umwandlung von Sonnenstrahlung in Strom von den Solarzellen freigesetzt wird, und dies ist ja bis zu 90% der eingestrahlten Energie der Fall. Die bei der Elektroenergieumwandlung freiwerdende thermische Energie an den Oberflächen der Solarzellen wird zugunsten der Elektroenergieausbeute vermindert bzw. effektiver genutzt. Solche Solarzellenanordnungen können genutzt werden bei Ein- und Mehrfamilienhäuser, mobilen Objekten wie Booten und Zügen, bei kommunalen, landwirtschaftlichen und industriellen Objekten und dgl. mehr. Überall dort jedenfalls, wo sowohl elektrische Energie wie auch Wärme, z. B. zur Warmwasserbereitung benötigt wird bzw. verwertet werden kann.
Es ist bekannt, Solarzellen auf einem von Flüssigkeit oder Gas durchströmten wärmetauscherartigen Element aufzubringen und über die Wandung dieses Elementes die bei der Erzeugung elektrischer Energie freiwerdende Wärme abzuführen und einer Nutzung zuzuführen. Durch die Wärmeabgabe erhöht sich der Wirkungsgrad der Umwandlung von Solarenergie in Elektroenergie und somit bei Nutzung des erwärmten Wärmeträgermediums der Gesamtwirkungsgrad der Solarenergieumsetzung. Die bislang vorgeschlagenen Verbundlösungen sind zwar hinsichtlich bestimmter Anwendungsfälle sehr vorteilhaft, jedoch ist zu beachten, daß die Herstellung eines solchen Verbundes technologisch wie auch ökonomisch aufwendig ist, und eine Vielzahl von Einzelproblemen insbesondere hinsichtlich unterschiedlicher Ausdehnungsquotienten, unterschiedlicher Kurz- und Langzeitbelastbarkeiten der Solarzellen bzw. der Beschichtungsmaterialien und Elementmaterialien zu beachten ist. Zudem sind aufwendige Kapselungen der Solarzellen erforderlich, um einen zuverlässigen Schutz der empfindlichen Solarzellen vor äußeren Einflüssen wie Korrosion, Staub, Hagelschlag usw. zu ermöglichen.

Ausgehend von dem vorbeschriebenen Stand der Technik wird ein Ziel der vorliegenden Erfindung darin gesehen, eine Solarzellenanordnung anzugeben, mit welcher möglichst vorteilhaft sowohl thermische wie auch elektrische Energie aus Solarstrahlung nutzbar gemacht werden kann.

Diese Aufgabe ist zunächst und im wesentlichen beim Gegenstand des Anspruches 1 gelöst, wobei darauf abgestellt ist, daß die Solarzellen unmittelbar vor- und rückseitig von dem Fluid umströmbar sind. Erfindungsgemäß ist erkannt worden, daß ein strahlungstransparentes Fluid, bestehend aus Paraffin, aufgrund der wesentlich besseren Wärmeübergangsbedingungen, auch vorderseitig vor Solarzellen vorbeigeführt werden kann, wobei die erreichten Vorteile durch Abführung der entstehenden Abstrahlungswärme der Solarzellen die etwas, jedoch nicht wesentlich beeinträchtigte, auf die Vorderseite der Solarzellen nach Durchgang durch das Fluid noch auftreffende Strahlung mehr als ausgleicht. Die Solarzellen können bei dieser Anordnung jedoch, da sie nicht unmittelbar äußeren Einflüssen ausgesetzt sind, wesentlich "abgemagert" werden, d.h. für ihren mechanischen Schutz ist nicht viel Aufwand zu treiben. Erfindungsgemäß ist vorgesehen, daß die Solarzellen selbst ungekapselt sind. Erfindungsgemäß ist also vorgesehen, die kompletten, kontaktierten Solarzellen unmittelbar in der Form, in der sie hergestellt werden, einzusetzen. Weiterhin ist vorgesehen, daß die Solarzellen aufgrund natürlicher Konvektion von dem Fluid umströmt werden. Die Strömungswege vor und hinter den Solarzellen sind entsprechend derart ausgestaltet, daß sich eine deutliche natürliche Konvektion ergibt und aufrechterhalten bleibt. Dies wird bspw. bevorzugt dadurch erreicht, daß die Tiefe der Strömungswege, d.h. eine Dicke einer Fluidschicht auf der Vorder- bzw. der Rückseite einer Solarzelle unterschiedlich ist. Es empfiehlt sich, die Fluiddicke auf der Vorderseite der Solarzelle relativ klein vorzusehen, auf der Rückseite der Solarzelle dagegen relativ groß. Bspw. kann eine Tiefe des Strömungsweges auf der Vorderseite 2 bis 5 mm betragen, auf der Rückseite dagegen ein Mehrfaches, bspw. das Zwei- bis Vierfache. Weiterhin ist bevorzugt vorgesehen, daß das Fluid elektrisch nicht leitend ist. Dies ermöglicht es, auch hinsichtlich der elektrischen Anschlüsse die Solarzellen gleichsam im Rohzustand zu belassen. Eine aufwendige Isolierung der Anschlüsse oder anderer Teile der Solarzellen ist nicht erforderlich. Erfindungsgemäß wird ein Fluid auf Paraffin-Basis, wie es für Latentwärmespeicher an sich bekannt ist. In Anpassung an die von dem Fluid in vorliegendem Zusammenhang auszuübende Funktion ist gewünscht, daß das Fluid über ein breites Temperaturspektrum flüssig ist, wozu vorzugsweise ein C14-Paraffin zur Anwendung kommt. In weiterer Ausgestaltung ist vorgesehen, daß das Fluid, welches die Solarzellen unmittelbar umströmt, in einem geschlossenen System strömt. Vorzugsweise besteht das System im wesentlichen nur aus einem Strömungsweg auf der Vorder- und einem Strömungsweg auf der Rückseite der Solarzellen. Darüber hinaus können aber auch noch kurzschlußartige Strömungswege, über die Höhe verteilt, zwischen den Solarzellen vorgesehen sein. Dies bekommt bspw. einen Sinn, wenn die Solarzellenanordnung teilweise beschattet ist. Es kann sich dann eine gewisse Umlaufströmung auch nur in einem (unteren) Teil der Solarzellenanordnung ausbilden. Die Aufheizung des Fluids erfolgt auf der Vorderseite, während der rückseitige Strömungsweg des Fluids wiederum im Wärmetausch zu einem zweiten Fluid geführt ist. Ein Strömungsweg für das zweite Fluid ist entsprechend in Form einer weiteren Schicht unterhalb bzw. ebenenmäßig benachbart des bezüglich der Solarzellen rückseitigen Strömungsweges des Fluids ausgebildet. Bevorzugt ist der Strömungsweg für das zweite Fluid über die gesamte Länge (und entsprechend auch Breite) des Strömungsweges des ersten Fluids auf der Rückseite der Solarzellen. In diesem Zusammenhang ist es ganz besonderes bevorzugt, wenn das zweite Fluid ein Latentspeichermedium eines Latentwärmespeichers ist oder mit einem solchen Latentwärmespeicher im Wärmetausch steht. Bezüglich der Latentwärmespeicher ist auf einen umfangreichen Stand der Technik zu verweisen. Weitere vorteilhafte Maßnahmen betreffen die Halterung der Solarzellen bezüglich der vorder- und rückseitigen Strömungswege des ersten Fluids. In diesem Zusammenhang ist es bevorzugt, daß die Solarzellen mittels vorder- und rückseitiger Abstandsnoppen gehaltert sind. Bspw. kann der Aufbau im einzelnen so gestaltet sein, daß auf einer Gehäusewand (transparenten Vorderwand) rasterartig Noppen angeordnet sind, auf welche die Solarzellen aufgelegt werden können. Auf einer weiteren Gehäusewand (Rückwand) sind in gleicher Weise Noppen angeordnet. Durch Zusammenlegen der Noppenseiten dieser beiden Gehäusewände ergibt sich ein Gesamtgehäuse, das aus einer ersten Gehäusewand, Noppen, den zischengelegten Solarzellen, weiteren Noppen der zweiten Gehäusewand und der zweiten Gehäusewand besteht. Hierbei ist entsprechend die erste Gehäusewand strahlungstransparent ausgebildet, um die Solarstrahlung zu den Solarzellen durchtreten zu lassen. Die Noppenlängen sind entsprechend den weiter oben stehenden Ausführungen unterschiedlich vorgesehen, so daß sich auf der Vorderseite der Solarzellen, welche der Sonnenstrahlung zugewandt ist, ein in seiner Tiefe (Dicke) kleinerer Strömungsweg als auf der Rückseite der Solarzellen ergibt. In diesem Zusammenhang kann es sich auch empfehlen, eine Wand, bspw. die vordere Wand, flexibel auszugestalten. Dies kann insbesondere dann von Bedeutung sein, wenn es gewünscht ist, die Aufteilung der Ausbeutung zwischen elektrischer und thermischer Energie zu verändern. Durch eine Veränderung der Tiefe des Strömungsweges auf der Vorderseite der Solarzellen ändert sich auch die relative Ausbeute an elektrischer Energie. Eine Vergrößerung der Dicke dieses Strömungsweges führt zu einer Verminderung an Ausbeute an elektrischer Energie, ungekehrt eine Verkleinerung der Dicke zu einer Erhöhung der Ausbeute an elektrischer Energie. Soweit eine oder beide Gehäusewände flexibel ausgebildet sind, kann mittels einer Pumpe oder dgl. der Systemdruck des Fluids erhöht oder abgesenkt werden. Wenn auch, wie weiter vorstehend im einzelnen beschrieben, ein Naturumlauf des ersten Fluids bevorzugt ist, kann gleichwohl auch ein Zwangsumlauf mittels einer Pumpe oder dgl. sich empfehlen, nicht zuletzt im Hinblick auf die zuletzt angesprochene Steuerung der Aufteilung der Energieausbeute.

Nachstehend ist die Erfindung des weiteren anhand der beigefügten Zeichnung, die jedoch lediglich ein Ausführungsbeispiel darstellt, erläutert. Hierbei zeigt:
- Fig. 1: eine Draufsicht auf eine rückseitige Gehäusewand mit einem Noppenraster, teilweise belegt mit Solarzellen;
- Fig. 2: eine Schnittdarstellung einer Solarzellenanordnung;
- Fig. 3: eine vergrößerte Schnittdarstellung eines Ausschnitts aus der Darstellung gemäß Fig. 2.

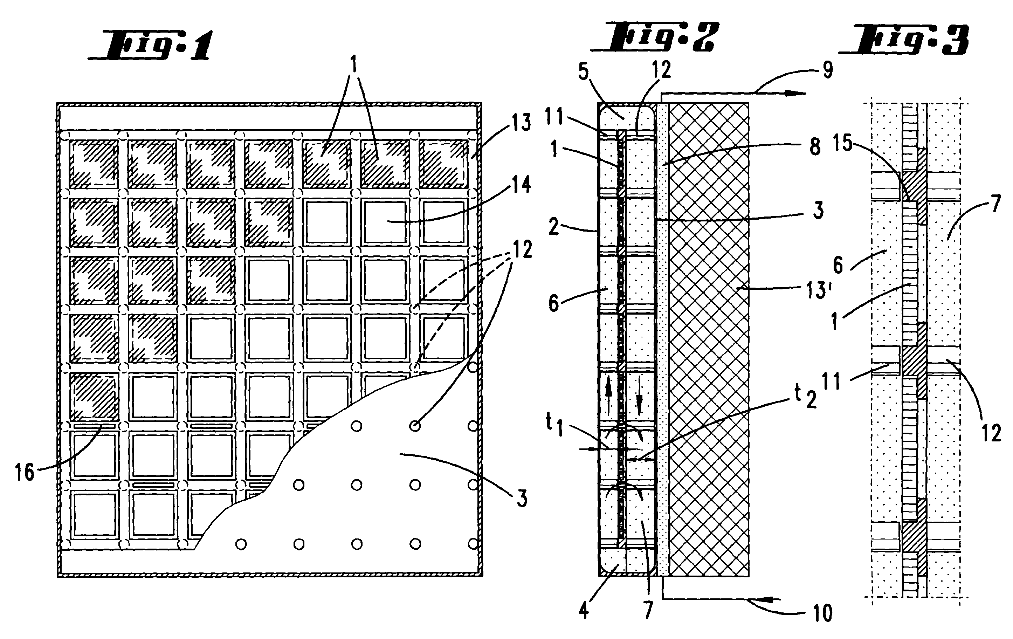

Mit Bezug zunächst zu Fig. 2 ist eine Solarzellenanordnung dargestellt, die aus Solarzellen 1 besteht, die zwischen einer vorderseitigen, transparenten Gehäusewand 2 und einer rückseitigen Gehäusewand 3 angeordnet sind. Ober- und unterseitig bezüglich der dargestellten Anordnung sind Strömungsverbindungen 4 bzw. 5 geschaffen, welche eine Umströmung der Solarzellen 1 durch das in dem Gehäuse befindliche Fluid auf Paraffin-Basis von einem vorderseitigen Strömungsweg 6 zu einem rückseitigen Strömungsweg 7 ermöglicht. Insgesamt ist das System der Strömungswege 6, 7 einschließlich der Umleitungen 4, 5 ein geschlossenes Strömungssystem.

Bei den Solarzellen 1 handelt es sich um unverkleidete Solarzellen unmittelbar in der für hergestellte Solarzellen üblichen Ausgestaltung. Da das Fluid zudem elektrisch isolierend ist, sind auch keine weiteren Isolationsmaßnahmen an den elektrischen Anschlüssen der Solarzellen erforderlich. Die Verwendung eines Fluids auf Paraffin-Basis ist auch mit einem wesentlichen weiteren Vorteil verbunden. Sollte die Temperatur des Systems einmal soweit absinken, daß das Fluid erstarrt, wird der Umlauf unterbrochen. Hierbei wirkt das Fluid darüber hinaus auch kälteisolierend, so daß eine Entladung des wärmetechnisch nachgeschalteten Speichers behindert bzw. stark verzögert wird.

Bei dem dargestellten Ausführungsbeispiel ist weiter rückseitig bzw. unterseitig zu dem hinteren Strömungsweg 7 ein Wärmetauschergehäuse 8 vorgesehen, in welchem ein zweites Fluid als Wärmeträgermedium, bevorzugt im Gegenstrom zu dem ersten Fluid, strömt. Das in dem zweiten Gehäuse strömende Fluid wird über eine Leitung 9, bspw.zu einem Verbraucher oder einem Wärmespeicher, insbesondere einem Latentwärmespeicher geführt. Der Rücklauf ist über die untere Leitung 10 vorgesehen. Bei dem Wärmeträgermedium in dem Gehäuse 8 kann es sich bspw. um gewöhnliches Wasser handeln. Weiter unterhalb des Gehäuses 8 bzw., gemäß der Darstellung in Fig. 2, in einer weiteren Schicht, ist eine Wärmedämmung 13' vorgesehen.

Die vordere Gehäusewand ist transparent, besteht also bspw. aus Glas oder durchsichtigem Kunststoff.

Eine Tiefe (Dicke) t1 des vorderen Strömungsweges 6 ist bedeutend kleiner als eine Tiefe (Dicke) t2 des hinteren Strömungsweges 7. Hierdurch läßt sich ein wirkungsvoller Naturumlauf des ersten Fluids erreichen. Beim Durchströmen des ersten Strömungsweges 6 wird das Fluid der Sonneneinstrahlung ausgesetzt und nimmt überdies im Wärmetausch von den Solarzellen 1 Wärme auf, so daß es insgesamt zu einer erheblichen Erwärmung des Fluids, das in dem Strömungsweg 6 strömt, kommt. Hiermit ist eine Ausdehnung verbunden, wohingegen auf der Rückseite, in dem Strömungsweg 7, Wärme abgeführt wird und das Fluid sich entsprechend zusammenzieht. Hierdurch wird insgesamt ein wirkungsvoller Naturumlauf erreicht.

Es ist weiter zu erkennen, daß die Solarzellen 1 durch Noppen 11, 12 gehalten sind, die von der rückwärtigen Gehäusewand 3 bzw. der vorderen Gehäusewand 1 ausgehen. Zusätzlich können die Noppen noch durch Rastmittel gegeneinander verbunden sein.

Im einzelnen ist dies weiter erläutert in bezug zu Fig. 1. Hier ist die rückwärtige Gehäusewand 3 zu erkennen, auf welcher Noppen 12 rasterartig angeordnet sind. Im oberen Bereich der Gehäusewand 3 ist in der Darstellung gemäß Fig. 1 eine Reihe von Solarzellen 1 bereits auf die Noppen 12 aufgelegt.

Es ist auch noch bevorzugt vorgesehen, daß auf die Noppen 12 ein maskenartiges Kunststoffteil 13 aufgelegt ist, das eine Vielzahl von in der Regel quadratischen Öffnungen 14 aufweist.

Wie sich insbesondere aus der Querschnittsdarstellung gemäß Fig. 3 ergibt, ist im einzelnen in dem Kunststoffteil 13 darüber hinaus eine Stufe 15 ausgebildet, in welche die Solarzellen 1 eingelegt werden können. Sie können dort auch verhaftet werden. Andererseits ist es zur Halterung der Solarzellen 1 im eingebauten Zustand auch möglich, den Fuß eines oberen Noppen 11 zu verbreitern.

In Fig. 1 ist auch angedeutet, daß in einem, bevorzugt unteren, Bereich der Solarzellenanordnung in dem Kunststoffteil 13 Durchgangsöffnungen 16 ausgebildet sind, zwischen zwei eingelegten Solarzellen 1. Hierdurch ist es möglich, daß gleichsam im Kurzschluß bzw. Bypass, wie durch die Pfeile in Fig. 2 angedeutet, sich auch nur eine über einen gewissen Abschnitt begrenzte Umlaufströmung ausbilden kann bzw. zusätzlich ausbildet.

Das Kunststoffteil 13 kann auch - was im einzelnen nicht dargestellt ist - an den Kreuzungspunkten der die Öffnungen 14 bildenden Stege, also im Zusammenbauzustand im Bereich der Noppen 11 bzw. 12, Öffnungen aufweisen, durch welche ein Verbindungsstab zwischen einzelnen Noppen 11 und 12 hindurchgesteckt werden kann, der bspw. mit einem der Noppen 11 oder 12 fest verbunden sein kann und für welchen darüber hinaus in dem anderen Noppen eine Aufnahmebohrung ausgebildet sein kann. Andererseits kann auch das Kunststoffteil 13 solche Fortsätze aufweisen, die in entsprechender Aufnahmebohrungen in den Noppen 11 bzw. 12 nach Zusammenbau aufgenommen sind.

## Patentansprüche

1. Solarzellenanordnung, wobei die Solarzellen (1) mit einem Fluid zur Abführung von Wärme zusammengeschaltet sind und unmittelbar vor- und rückseitig von dem Fluid, das transparent ist, umströmbar sind, dadurch gekennzeichnet, daß die Solarzellen (1) ungekapselt sind, daß das Fluid elektrisch nicht leitend ist und daß das Fluid aus Paraffin besteht.

2. Solarzellenanordnung nach Anspruch 1, dadurch gekennzeichnet, daß das Fluid die Solarzellen (1) aufgrund natürlicher Konvektion umströmt.

3. Solarzellenanordnung nach einem oder mehreren der vorhergehenden Ansprüche, dadurch gekennzeichnet, daß eine Schichtdicke des Fluids auf einer der Solarstrahlung ausgesetzen Vorderseite der Solarzellen dünn ist, beispielsweise 2 bis 5 mm beträgt.

4. Solarzellenanordnung nach einem oder mehreren der vorhergehenden Ansprüche, dadurch gekennzeichnet, daß das Fluid in einem geschlossenen System, das im wesentlichen nur aus den Strömungswegen vor und hinter den Solarzellen (1) besteht, umläuft.

5. Solarzellenanordnung nach einem oder mehreren der vorhergehenden Ansprüche, dadurch gekennzeichnet, daß das die Solarzellen (1) umströmende Fluid im Wärmetausch zu einem zweiten Fluid geführt ist.

6. Solarzellenanordnung nach einem oder mehreren der vorhergehenden Ansprüche, dadurch gekennzeichnet, daß ein Strömungsweg des zweiten Fluids entsprechend einer weiteren Schicht unterhalb eines bezüglich der Solarzellen (1) rückseitigen Strömungsweges (7) des ersten Fluides ausgebildet ist.

7. Solarzellenanordnung nach einem oder mehreren der vorhergehenden Ansprüche, dadurch gekennzeichnet, daß das zweite Fluid ein Latentspeichermedium eines Latentwärmespeichers ist oder mit einem solchen in Wärmetausch steht.

8. Solarzellenanordnung nach einem oder mehreren der vorhergehenden Ansprüche, dadurch gekennzeichnet, daß die Solarzellen (1) mittels vorder- und rückseitiger Abstandsnoppen (11, 12) gehaltert sind.

9. Solarzellenanordnung nach einem oder mehreren der vorhergehenden Ansprüche, dadurch gekennzeichnet, daß die Abstandsnoppen (11, 12) die Solarzellen (1) zwischen einer vorderen, transparenten Wand (2) und einer rückwärtigen Wand (3), welche Wände (2, 3) gleichzeitig den vorderen und rückwärtigen Strömungsweg 6, 7) des Fluids begrenzen, haltern.

10. Solarzellenanordnung nach einem oder mehreren der vorhergehenden Ansprüche, dadurch gekennzeichnet, daß eine Wand (2, 3), bspw. die vordere Wand, flexibel ist.

11. Solarzellenanordnung nach einem oder mehreren der vorhergehenden Ansprüche, dadurch gekennzeichnet, daß die Strömung des ersten Fluids, bspw. durch eine zwischengeschaltete Pumpe erreicht, eine Zwangsströmung ist.

12. Solarzellenanordnung nach einem oder mehreren der vorhergehenden Ansprüche, dadurch gekennzeichnet, daß ein Fluiddruck des ersten Fluids einstellbar ist.

13. Solarzellenanordnung nach einem oder mehreren der vorhergehenden Ansprüche, dadurch gekennzeichnet, daß die Solarzellen (1) in einem Öffnungen (4) aufweisenden Kunststoffteil (13) aufgenommen sind.

14. Solarzellenanordnung nach einem oder mehreren der vorhergehenden Ansprüche, dadurch gekennzeichnet, daß das Kunststoffteil (13) mit den eingelegten Solarzellen (1) zwischen den Noppen (11, 12) gehaltert ist.

## Claims

1. Solar cell arrangement wherein the solar cells (1) are interconnected with a fluid for the dissipation of heat and around which the fluid, which is transparent, can directly flow on the front and reverse sides, characterised in that the solar cells (1) are encapsulated, that the fluid is electrically non-conducting and that the fluid consists of paraffin.

2. Solar cell arrangement according to Claim 1, characterised in that the fluid flows around the solar cells (1) on account of natural convection.

3. Solar cell arrangement according to one or more of the preceding claims, characterised in that a film thickness of the fluid on a front side of the solar cells exposed to the solar radiation is thin and amounts for example to 2 to 5 mm.

4. Solar cell arrangement according to one or more of the preceding claims, characterised in that the fluid circulates in a closed system which consists substantially only of the flow pathways in front of and behind the solar cells (1).

5. Solar cell arrangement according to one or more of the preceding claims, characterised in that the fluid flowing around the solar cells (1) is conveyed in a heat-exchanging relationship with a second fluid.

6. Solar cell arrangement according to one or more of the preceding claims, characterised in that a flow path for the second fluid is constructed in accordance with a further layer below a flow path (7) of the first fluid on the reverse side with reference to the solar cells (1).

7. Solar cell arrangement according to one or more of the preceding claims, characterised in that the second fluid is a latent storage medium of a latent heat reservoir or exchanges heat with one of these.

8. Solar cell arrangement according to one or more of the preceding claims, characterised in that the solar cells (1) are mounted by means of spacing nubs (11, 12) on the front and reverse sides.

9. Solar cell arrangement according to one or more of the preceding claims, characterised in that the spacing nubs (11, 12) fix the solar cells (1) between a front, transparent wall (2) and a rearward wall (3) which walls (2, 3) simultaneously bound the front and reverse flow paths (6, 7) of the fluid.

10. Solar cell arrangement according to one or more of the preceding claims, characterised in that one wall (2, 3), the front wall for example, is flexible.

11. Solar cell arrangement according to one or more of the preceding claims, characterised in that the flow of the first fluid, achieved for example by means of an interposed pump, is a forced flow.

12. Solar cell arrangement according to one or more of the preceding claims, characterised in that a fluid pressure can be set for the first fluid.

13. Solar cell arrangement according to one or more of the preceding claims, characterised in that the solar cells (1) are accommodated in a plastic part (13) possessing openings (4).

14. Solar cell arrangement according to one or more of the preceding claims, characterised in that the plastic part (13) with the inserted solar cells (1) is fixed between the nubs (11, 12).

## Revendications

1. Dispositif à cellules solaires, dans lequel les cellules solaires (1) sont branchées en circuit ensemble, avec un fluide pour l'évacuation de la chaleur, et sont susceptibles d'être parcourues par un écoulement directement en face avant et arrière du fluide, qui est transparent, caractérisé en ce que les cellules solaires (1) sont non encapsulées, en ce que le fluide n'est pas conducteur de l'électricité, et en ce que le fluide est constitué de paraffine.

2. Dispositif à cellules solaires selon la revendication 1, caractérisé en ce que le fluide parcourt les cellules solaires (1) par l'effet de la convexion naturelle.

3. Dispositif à cellules solaires selon l'une ou plusieurs des revendications précédentes, caractérisé en ce que l'épaisseur de couche du fluide sur la face avant, exposée au rayonnement solaire, des cellules solaires est mince, par exemple de 2 à 5 mm.

4. Dispositif à cellules solaires selon l'une ou plusieurs des revendications précédentes, caractérisé en ce que le fluide circule dans un système fermé, constitué essentiellement uniquement des trajets d'écoulement se trouvant devant et derrière les cellules solaires (1).

5. Dispositif à cellules solaires selon l'une ou plusieurs des revendications précédentes, caractérisé en ce que le fluide s'écoulant autour des cellules solaires (1) est guidé en échange thermique par rapport à un deuxième fluide.

6. Dispositif à cellules solaires selon l'une ou plusieurs des revendications précédentes, caractérisé en ce qu'une voie d'écoulement du deuxième fluide est réalisée de manière correspondante à une autre couche, se trouvant au-dessous d'un trajet d'écoulement (7) du premier fluide, situé en face arrière par rapport aux cellules solaires (1).

7. Dispositif à cellules solaires selon l'une ou plusieurs des revendications précédentes, caractérisé en ce que le deuxième fluide est un milieu d'accumulation de chaleur latente d'un accumulateur de chaleur latente, ou bien est mis en échange thermique avec un tel milieu.

8. Dispositif à cellules solaires selon l'une ou plusieurs des revendications précédentes, caractérisé en ce que les cellules solaires (1) sont maintenues au moyen de tétons d'espacement (11, 12) situés en face avant et en face arrière.

9. Dispositif à cellules solaires selon l'une ou plusieurs des revendications précédentes, caractérisé en ce que les tétons d'espacement (11, 12) maintiennent les cellules solaires (1) entre une paroi avant (2) transparente et une paroi arrière (3), les parois (2, 3) délimitant simultanément les trajets d'écoulement avant et arrière (6, 7) du fluide.

10. Dispositif à cellules solaires selon l'une ou plusieurs des revendications précédentes, caractérisé en ce qu'une paroi (2, 3), par exemple la paroi avant est flexible.

11. Dispositif à cellules solaires selon l'une ou plusieurs des revendications précédentes, caractérisé en ce que l'écoulement du premier fluide est obtenu par exemple au moyen d'une pompe interposée dans le circuit, qui est une pompe volumétrique.

12. Dispositif à cellules solaires selon l'une ou plusieurs des revendications précédentes, caractérisé en ce que la pression du premier fluide est réglable.

13. Dispositif à cellules solaires selon l'une ou plusieurs des revendications précédentes, caractérisé en ce que les cellules solaires (1) sont logées dans une pièce en matière synthétique (13) présentant des ouvertures (4).

14. Dispositif à cellules solaires selon l'une ou plusieurs des revendications précédentes, caractérisé en ce que la pièce en matière synthétique (13) est maintenue, avec les cellules solaires (1) insérées, entre les tétons (11, 12).
